Europäisches Patentamt

European Patent Office

Office européen des brevets

(19)

(11) **EP 0 540 906 B1**

(12) **EUROPÄISCHE PATENTSCHRIFT**

(45) Veröffentlichungstag und Bekanntmachung des Hinweises auf die Patenterteilung:
**06.08.1997  Patentblatt 1997/32**

(51) Int Cl.$^6$: **H03D 1/22**, G01R 25/00, H03F 1/30

(21) Anmeldenummer: **92117464.5**

(22) Anmeldetag: **13.10.1992**

(54) **Phasenempfindliche Gleichrichteranordnung mit Integrationswirkung**

Phase-sensitive rectifying device with integrating effect

Dispositif redresseur sensible à la phase avec effet intégrateur

(84) Benannte Vertragsstaaten:
**DE FR GB IT**

(30) Priorität: **29.10.1991  DE 4135644**

(43) Veröffentlichungstag der Anmeldung:
**12.05.1993  Patentblatt 1993/19**

(73) Patentinhaber: **SGS-THOMSON MICROELECTRONICS GMBH**
**85630 Grasbrunn (DE)**

(72) Erfinder: **Kirchlechner, Peter**
**W-8201 Hohentann (DE)**

(74) Vertreter: **Klunker . Schmitt-Nilson . Hirsch**
**Winzererstrasse 106**
**80797 München (DE)**

(56) Entgegenhaltungen:
**DE-A- 3 301 792**

- **1981 IEEE INTERNATIONAL SYMPOSIUM ON CIRCUITS AND SYSTEMS PROCEEDINGS Bd. 2, 27. April 1981, CHICAGO, ILLINOIS Seiten 517 - 518 KEN MARTIN ET AL. 'Switched Capacitor Building Blocks for Adaptive Systems'**
- **JOURNAL OF PHYSICS E. SCIENTIFIC INSTRUMENTS Bd. 15, Nr. 4, April 1982, DORKING, GREAT BRITAIN Seiten 395 - 403 M.L. MEADE 'Advances in Lock-in Amplifiers'**

**Beschreibung**

Die Erfindung betrifft eine phasenempfindliche Gleichrichteranordnung mit Integrationswirkung zur Verknüpfung zweier Eingangssignale, mit einem Operationsverstärker, dessen invertierender Eingang über eine erste Kapazität mit einer erstes Eingangssignal liefernden Eingangssignalquelle gekoppelt ist und dessen nicht invertierender Eingang an ein Referenzpotential gelegt ist, mit einer zweiten Kapazität, die zwischen den invertierenden Eingang und den Ausgang des Operationsverstärkers geschaltet ist, und mit einer steuerbaren Umschalteinrichtung, die mittels eines als Steuersignal dienenden zweiten Eingangssignals steuerbar ist.

Eine derartige Gleichrichteranordnung ist bekannt aus dem Buch "SWITCHED CAPACITOR CIRCUITS" von P.E. Allen und E. Sanchez-Sinencio, Van Nostrand Reinhold Company, New York, 1984, Seiten 456 und 457. Ferner ist aus 1981 IEEE INTERNATIONAL SYMPOSIUM ON CIRCUITS AND SYSTEMS PROCEEDINGS, Bd. 2, 27.04.1981, CHICAGO, ILLINOIS, Seiten 517-518, KEN MARTIN ET AL. "Switched Capacitor Building Blocs for Adaptive Systems" eine ähnliche Gleichrichteranordnung bekannt.

Aus: Tietze, U.; Schenk, Ch.: Halbleiter-Schaltungstechnik, Berlin: Springer-Verlag, 5. Aufl. 1980, Seiten 683-687, ist ein phasenempfindlicher Gleichrichter bekannt. Phasenempfindliche Gleichrichter lassen sich als Verstärker mit veränderlichem Verstärkungsfaktor auffassen, bei denen das Vorzeichen des Verstärkungsfaktors nicht zwangsläufig mit der Polarität der Eingangsspannung, sondern mit einer externen Steuerspannung umschaltet. Eine Verwendung eines herkömmlichen analogen Multiplizierers als phasenempfindlicher Gleichrichter ist ebenfalls aus der vorstehend genannten Druckschrift bekannt.

Ein phasenempfindlicher Gleichrichter wird häufig zusammen mit einem nachfolgenden Integrator, beispielsweise in PLL-Schaltungen und Demodulationsschaltungen, verwendet. Integratoren mit Operationsverstärkern, bei denen zwischen den Ausgang und den invertierenden Eingang eines Operationsverstärkers eine Kapazität geschaltet ist und bei denen das zu integrierende Signal über einen Widerstand dem invertierenden Eingang des Operationsverstärkers zugeführt wird, sind aus der letztgenannten Druckschrift, Seite 195, bekannt. Das Zeitverhalten eines derartigen Integrators ist durch die Zeitkonstante $R \cdot C$ aus dem Widerstandswert R des Widerstandes und dem Kapazitätswert C der Kapazität bestimmt.

Soll eine aus einem phasenempfindlichen Gleichrichter und einem Integrator bestehende Anordnung als Integrierte Schaltung (IC), insbesondere als IC mit engen Toleranzen hinsichtlich des Zeitverhaltens des Integrators, realisiert werden, so kann auf die Schaltkondensator-Technik (SC, switched capacitor) zurückgegriffen werden. Bei dieser Technik kann ein Widerstand durch eine geschaltete Kapazität nachgebildet werden.

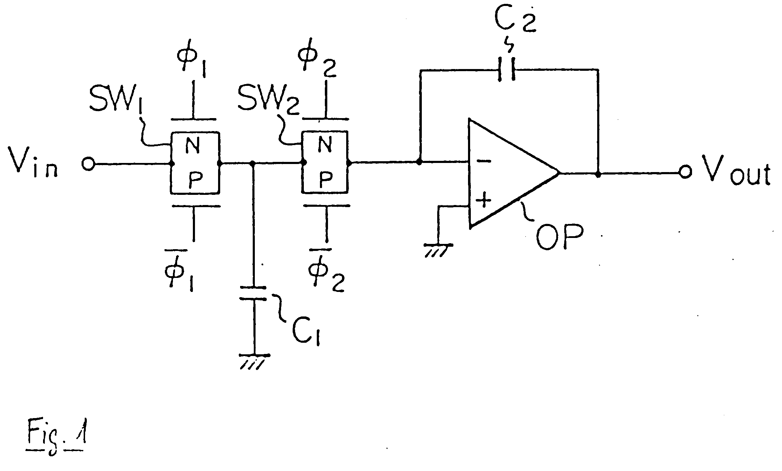

Ein Integrator in SC-Anordnung, im folgenden "Schaltkondensator-Integrationsschaltung" genannt, ist aus der Druckschrift EP-A1-0 053 014 bekannt und in beiliegender **Fig. 1** gezeigt. Ein Operationsverstärker OP weist im Gegenkopplungszweig eine Kapazität $C_2$ auf. Der invertierende Eingang des Operationsverstärkers OP ist über einen CMOS-Halbleiterschalter $SW_2$ mit einem ersten Anschluß einer Kapazität $C_1$ verbunden, deren zweiter Anschluß an ein Referenzpotential gelegt ist. Der erste Anschluß der Kapazität $C_1$ ist darüber hinaus über einen CMOS-Halbleiterschalter $SW_1$ mit einer Signalquelle verbunden. Der CMOS-Halbleiterschalter $SW_2$ wird durch ein erstes Taktsignal $ø_2$ angesteuert. Der CMOS-Halbleiterschalter $SW_1$ wird durch ein zu $ø_2$ gegenphasiges und überlappungsfreies zweites Taktsignal $ø1$ angesteuert. Beim Betrieb dieser Anordnung wird, während der Halbleiterschalter $SW_2$ geöffnet und der Halbleiterschalter $SW_1$ geschlossen ist, eine durch die Signalspannung der Signalquelle bestimmte Ladungsmenge auf die Kapazität $C_1$ aufgebracht. Diese Ladungsmenge wird, wenn der Halbleiterschalter $SW_2$ geschlossen und der Halbleiterschalter $SW_1$ geöffnet ist, auf die Kapazität $C_2$ übertragen. Das Zeitverhalten der Schaltkondensator-Integrationsschaltung wird durch das Verhältnis $C_2/C_1$ des Kapazitätswertes der Kapazität $C_2$ und des Kapazitätswertes der Kapazität $C_1$ bestimmt. Da sich bei einer Integrierten Schaltung das Verhältnis zweier Kapazitätswerte wesentlich leichter präzise einstellen läßt als ein RC-Wert, ist eine Schaltkondensator-Integrationsschaltung besonders für eine Implementierung als Integrierte Schaltung geeignet.

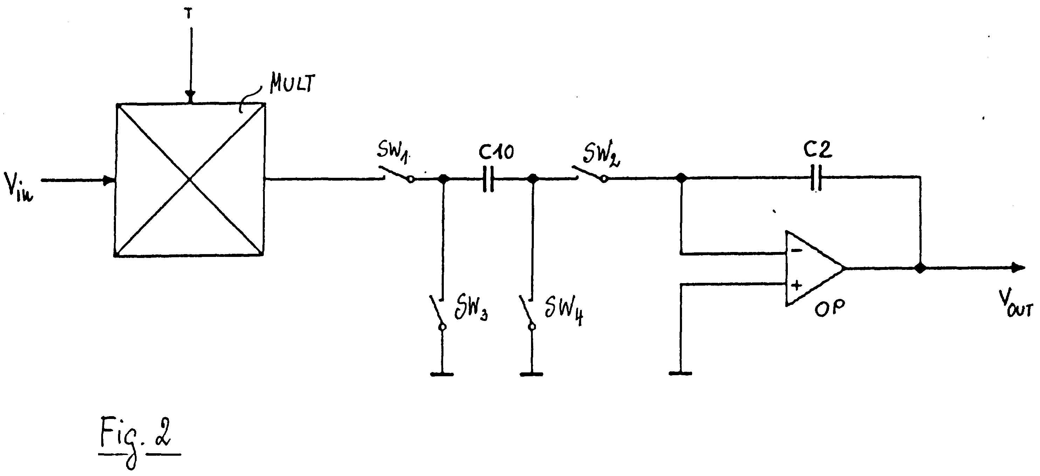

**Fig. 2** zeigt ein Prinzip-Schaltbild einer herkömmlichen phasenempfindlichen Gleichrichteranordnung mit Integrationswirkung. Eine ähnliche Gleichrichteranordnung, jedoch mit Tiefpaßverhalten, ist aus dem bereits genannten Buch "SWITCHED CAPACITOR CIRCUITS" bekannt. Der Ausgang eines Analogmultiplizierers MULT, dessen erstem Eingang ein Eingangssignal $V_{in}$ und dessen zweitem Eingang ein Steuersignal T zugeführt wird, ist über eine steuerbare Schaltereinrichtung $SW_1$ mit einem Anschluß einer Kapazität $C_{10}$ verbunden. Der zweite Anschluß der Kapazität $C_{10}$ ist über eine steuerbare Schaltereinrichtung $SW_2$ mit dem invertierenden Eingang eines Operationsverstärkers OP verbunden. Zwischen den Ausgang und den invertierenden Eingang des Operationsverstärkers OP ist eine Kapazität $C_2$ geschaltet. Über eine steuerbare Schaltereinrichtung SW3 bzw. eine Schaltereinrichtung SW4 kann der erste Anschluß bzw. der zweite Anschluß der Kapazität $c_{10}$ selektiv an ein Referenzpotential gelegt werden. Der Betriebszyklus der Schaltung umfaßt eine erste und eine zweite Halbperiode. Während der ersten Halbperiode sind die beiden Schaltereinrichtungen $SW_3$ und $SW_4$ leitend geschaltet, während die Schaltereinrichtungen $SW_1$ und $SW_2$ nicht-leitend geschaltet sind. Dadurch wird die Kapazität $C_{10}$ entladen. Während der zweiten Halbperiode sind die beiden Schaltereinrichtun-

gen $SW_3$ und $SW_4$ nicht-leitend und die Schaltereinrichtungen $SW_1$ und $SW_2$ leitend geschaltet. Dadurch wird eine der Ausgangsspannung des Analogmultiplizierers MULT proportionale Ladung auf die Kapazität $C_2$ übertragen und dort periodisch aufintegriert. Die mit Hilfe der Schaltereinrichtungen SW1 bis SW4 geschaltete Kapazität $C_{10}$ bildet dabei einen ohmschen Widerstand nach.

Die phasenempfindliche Gleichrichteranordnung nach **Fig. 2** weist den Nachteil auf, daß zu ihrer Realisierung zahlreiche Bauelemente erforderlich sind. Bei sehr großen Zeitkonstanten für den Integrator tritt darüber hinaus das Problem auf, daß für das Kapazitätsverhältnis $C_2/C_{10}$ derart große Werte erforderlich sind, daß eine Schaltung nach Fig. 2 nicht mehr zweckmäßig als Integrierte Schaltung realisiert werden kann.

Eine Aufgabe der Erfindung ist es daher, eine phasenempfindliche Gleichrichteranordnung der eingangs angegebenen Art verfügbar zu machen, die aus einem Minimum an Bauelementen aufgebaut werden kann und die darüber hinaus für die Implementierung als integrierte Schaltung auch bei sehr großen Zeitkonstanten für den Integrator geeignet ist.

Diese Aufgabe wird durch die phasenempfindlichen Gleichrichteranordnungen entsprechend der Ansprüche 1 und 2 gelöst. Dabei ist für die eingangs angegebene phasenempfindliche Gleichrichteranordnung eine dritte Kapazität vorgesehen , die einen Endes mit dem Ausgang des Operationsverstärkers und anderen Endes über die Umschalteinrichtung in Abhängigkeit von dem Steuersignal entweder mit dem invertierenden Eingang verbindbar oder mit dem Referenzpotential koppelbar ist.

Die erfindungsgemäße phasenempfindliche Gleichrichteranordnung ist für verschiedene Anwendungen einsetzbar. Beispiele sind PLL-Schaltungen, Frequenzmischerschaltungen und Demodulatoren.

Für die erfindungsgemäße phasenempfindliche Gleichrichteranordnung wird ein gegengekoppelter Operationsverstärker verwendet, wobei dessen Gegenkopplung entweder nur durch die zweite Kapazität oder durch eine Parallelschaltung von zweiter und dritter Kapazität bestimmt wird. Je nachdem, ob das Steuersignal die dritte Kapazität gerade mit dem Referenzpotential oder mit dem invertierenden Eingang des Operationsverstärkers verbindet, wirkt für die Gegenkopplung zwischen Ausgang und invertierendem Eingang des Operationsverstärkers nur die zweite Kapazität oder eine Parallelschaltung aus der zweiten Kapazität und der dritten Kapazität. Es ist also eine umschaltbare Gegenkopplung und damit eine umschaltbare Verstärkung des rückgekoppelten Operationsverstärkers gegeben. Sind beide Kapazitäten parallel geschaltet, ist die Gegenkopplungswirkung für den Operationsverstärker stärker und bei einem bestimmten Eingangssignal das Ausgangssignal kleiner als wenn die Gegenkopplung nur über die zweite Kapazität geschieht.

Am Ausgang der erfindungsgemäßen phasenempfindlichen Gleichrichteranordnung erscheint ein Ausgangssignal, das von der relativen Phasenlage von Eingangssignal und Steuersignal abhängt. Bei gegen- oder Gleichphasigkeit der beiden Signale entsteht am Ausgang ein Ausgangssignal mit einem konstanten Mittelwert. Im Fall einer Phasendifferenz zwischen beiden Signalen weist die Ausgangsspannung einen veränderlichen Mittelwert auf. Die erfindungsgemäße Schaltungsanordnung weist daher sowohl Phasenempfindlichkeit als auch Integratorwirkung auf. Sie vereint somit in sich die Eigenschaften eines phasenempfindlichen Gleichrichters als auch die Eigenschaften eines Integrators. Um diese beiden Funktionen gemeinsam zu erfüllen, sind lediglich ein Operationsverstärker, drei Kapazitäten und eine Umschalteinrichtung erforderlich.

Verwendet man die erfindungsgemäße phasenempfindliche Gleichrichteranordnung beispielsweise in einer PLL (Phase Locked Loop), wird als Steuersignal für die Umschalteinrichtung das Ausgangssignal eines spannungsgesteuerten Oszillators verwendet, dessen Frequenz auf die Frequenz eines Eingangssignals gebracht werden soll, das der erfindungsgemäßen phasenempfindlichen Gleichrichteranordnung als Eingangssignal zugeführt wird. Solange zwischen dem Eingangssignal und dem Steuersignal, d.h., dem Ausgangssignal des spannungsgesteuerten Oszillators, eine Phasendifferenz besteht, die von 180° verschieden ist, enthält das dem spannungsgesteuerten Oszillator als Steuersignal zugeführte Ausgangssignal der erfindungsgemäßen phasenempfindlichen Gleichrichteranordnung einen sich ändernden Mittelwert. Die Frequenz des spannungsgesteuerten Oszillators wird solange geändert, bis dieser Mittelwert konstant geworden ist. Da dies der Fall ist, wenn zwischen dem Eingangssignal und dem Steuersignal der erfindungsgemäßen phasenempfindlichen Gleichrichteranordnung eine Phasendifferenz von 0 besteht, bedeutet dies, daß die PLL dann auf die Frequenz des Eingangsignals synchronisiert ist.

Die vorausgehende Erläuterung geht davon aus, daß die erfindungsgemäße phasenempfindliche Gleichrichteranordnung auf Übereinstimmung der Phasen von Eingangssignal und Steuersignal steuern soll. Es gibt aber auch Schaltungsanwendungen, bei denen es erwünscht ist, Eingangssignal und Steuersignal auf einen Phasenunterschied von 90° zu steuern. Für diesen Fall braucht lediglich ein 90°-Phasenschieber eingefügt zu werden, beispielsweise in die Leitung, über welche der phasenempfindlichen Gleichrichteranordnung das Steuersignal zugeführt wird.

Man kann die Funktionsweise der erfindungsgemäßen phasenempfindlichen Gleichrichteranordnung auch anhand von Ladungsüberlegungen beschreiben. Nimmt man für den Fall, daß kein 90°-Phasenschieber vorhanden ist, beispielsweise an, daß zwischen dem Eingangsignal und dem Steuersignal gerade eine Phasendifferenz von 90° besteht, sieht die Überlegung hierfür folgendermaßen aus:

An die erste Kapazität wird eine Sinuswechselspannung als Eingangssignal angelegt. Während der fallenden Flanke des Eingangssignals wird die in der ersten Kapazität gesammelte Ladung auf die in der Rückkoppelungsschleife des Operationsverstärkers angeordnete zweite Kapazität übertragen. Während dieser Zeit, in der das Steuersignal einen ersten Pegel annimmt, ist das eine Ende der dritten Kapazität durch die steuerbare Umschalteinrichtung auf das Referenzpotential gelegt. Während der ansteigenden Flanke des Eingangssignals wird die in der ersten Kapazität gesammelte Ladung von der in der zweiten Kapazität gesammelten Ladung subtrahiert. Da jedoch das Steuersignal in diesem Zeitraum einen zweiten Pegel annimmt, ist die dritte Kapazität über die steuerbare Umschalteinrichtung der zweiten Kapazität parallelgeschaltet. Somit verbleibt eine kleine Ladung in der zweiten Kapazität. Dieser Ablauf wiederholt sich für jede Periode des Eingangssignals, so daß diese kleinen Ladungsmengen sich ansammeln.

Durch die erfindungsgemäße Anordnung wird eine Reihe von Vorteilen erzielt. Die erfindungsgemäße Anordnung benötigt ein Minimum an Bauelementen, das den Bauteilebedarf der bekannten Schaltungen beachtlich unterschreitet. Ferner ist sie in besonderem Maße für die Anwendung als Integrierte Schaltung oder als ein Teil einer solchen geeignet. Durch die Erfindung ist eine Schaltung verfügbar, mit der sehr große Zeitkonstanten mit kleinen Kapazitätswerten realisiert werden können. Auch diese Eigenschaft fördert die Eignung der erfindungsgemäßen Anordnung zur Anwendung bei Integrierten Schaltungen.

Eine bevorzugte Ausführungsform der Erfindung gemäß Anspruch 2 ermöglicht eine Offset-Kompensation des Operationsverstärkers. Zu diesem Zweck wird die dritte Kapazität zu Zeiten, in denen sie durch entsprechende Schaltstellung der ersten Umschalteinrichtung nicht in den Rückkopplungskreis des Operationsverstärkers geschaltet ist, im Zusammenwirken mit einer vierten Kapazität zur Offset-Kompensation herangezogen.

Dabei sind eine zweite und eine dritte Umschalteinrichtung durch ein zweites Steuersignal derart steuerbar, daß während eines Teils derjenigen Zeitdauer des ersten Steuersignals, während welcher die dritte Kapazität mit dem Referenzpotential gekoppelt ist, die dritte Kapazität mit dem invertierenden Eingang des Operationsverstärkers und die vierte Kapazität mit dem Referenzpotential und ansonsten die dritte Kapazität mit der ersten Umschalteinrichtung und die vierte Kapazität mit der ersten Kapazität gekoppelt ist.

Aus der DE 34 01 516 A1 ist eine Offset-Kompensation eines Operationsverstärkers an sich bekannt, allerdings für einen Schaltungs-Grundbaustein für ein SC-Filter, einen SC-Spannungsverstärker oder einen DA-Wandler.

Die Erfindung wird im folgenden anhand einiger Ausführungsbeispiele näher erläutert. In den zugehörigen Zeichnungen zeigen:

| Fig. 1 | ein Schaltbild einer Schaltkondensator-Integrationsschaltung nach dem Stand der Technik, |
| Fig. 2 | ein Schaltbild einer phasenempfindlichen Gleichrichteranordnung nach dem Stand der Technik, |
| Fig. 3 | ein Schaltbild eines ersten Ausführungsbeispiels einer erfindungsgemäßen phasenempfindlichen Gleichrichteranordnung, |
| Fig. 4 | ein Zeitdiagramm mit Signalverläufen bei einer Phasendifferenz von 90° zwischen Eingangssignal und Steuersignal; |
| Fig. 5 | ein Zeitdiagramm mit Signalverläufen bei einer Phasendifferenz von 180° zwischen Eingangssignal und Steuersignal; |
| Fig. 6 | ein Schaltbild eines zweiten Ausführungsbeispiels einer erfindungsgemäßen phasenempfindlichen Gleichrichteranordnung; |
| Fig. 7 | ein Zeitdiagramm mit Signalverläufen, einschließlich zweier Steuersignale T und Z; |
| Fig. 8 | ein Zeitdiagramm einer Ausgangsspannung einer Signalquelle, die dem Eingang einer erfindungsgemäßen phasenempfindlichen Gleichrichteranordnung zugeführt wird; |
| Fig. 9 | ein Zeitdiagramm der Spannung am Ausgang einer erfindungsgemäßen phasenempfindlichen Gleichrichteranordnung, wenn an deren Eingang die in **Fig. 8** dargestellte Spannung angelegt wird; |
| Fig. 10 | eine PLL mit herkömmlichem Schaltungsaufbau; und |
| Fig. 11 | eine PLL unter Verwendung einer dungsgemäßen phasenempfindlichen richteranordnung. |

Die **Fig. 1** und **Fig. 2** sind bereits vorstehend bei der Darlegung des Standes der Technik erläutert worden.

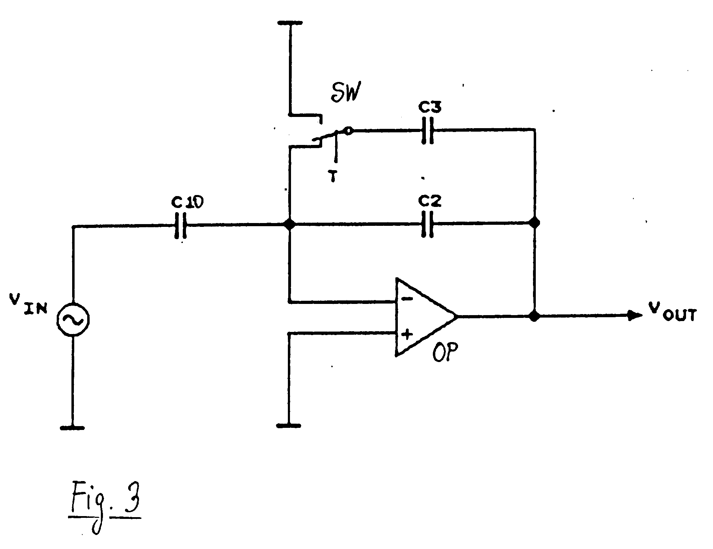

**Fig. 3** zeigt ein Schaltbild einer Ausführungsform einer erfindungsgemäßen phasenempfindlichen Gleichrichteranordnung mit Integrationswirkung. Der Ausgang einer Signalquelle wird als Eingangssignal $V_{IN}$ einem ersten Anschluß einer ersten Kapazität $C_{10}$ zugeführt. Der zweite Anschluß der ersten Kapazität $C_{10}$ ist unmittelbar an den invertierenden Eingang eines Operationsverstärkers OP geschaltet. Zwischen den Ausgang und den invertierenden Eingang des Operationsverstärkers OP ist eine zweite Kapazität $C_2$ geschal-

tet. Eine steuerbare Umschalteinrichtung SW weist einen ersten Anschluß, einen zweiten Anschluß und einen Mittenanschluß auf. In Abhängigkeit von einem elektrischen Steuersignal T ist bei einem ersten Pegel des Steuersignals T der zweite Anschluß mit dem Mittenanschluß und der erste Anschluß nicht mit dem Mittenanschluß verbunden, während bei einem zweiten Signalpegel des Steuersignals T der zweite Anschluß nicht mit dem Mittenanschluß und der erste Anschluß mit dem Mittenanschluß verbunden ist. Eine dritte Kapazität $C_3$ ist zwischen den Ausgang des Operationsverstärkers OP und den Mittenanschluß der steuerbaren Umschalteinrichtung SW geschaltet, wobei ein erster Anschluß der dritten Kapazität $C_3$ an den Mittenkontakt der steuerbaren Umschalteinrichtung SW und ein zweiter Anschluß der dritten Kapazität $C_3$ an den Ausgang des Operationsverstärkers OP geschaltet ist. Der zweite Anschluß der steuerbaren Umschalteinrichtung SW ist auf ein Referenzpotential gelegt, wohingegen der erste Anschluß der steuerbaren Umschalteinrichtung SW unmittelbar an den invertierenden Eingang des Operationsverstärkers OP geschaltet ist. Der nichtinvertierende Eingang des Operationsverstärkers OP ist auf das Referenzpotential gelegt. Das Ausgangssignal $V_{OUT}$ der phasenempfindlicher Gleichrichteranordnung wird an dem Ausgang des Operationsverstärkers OP abgenommen.

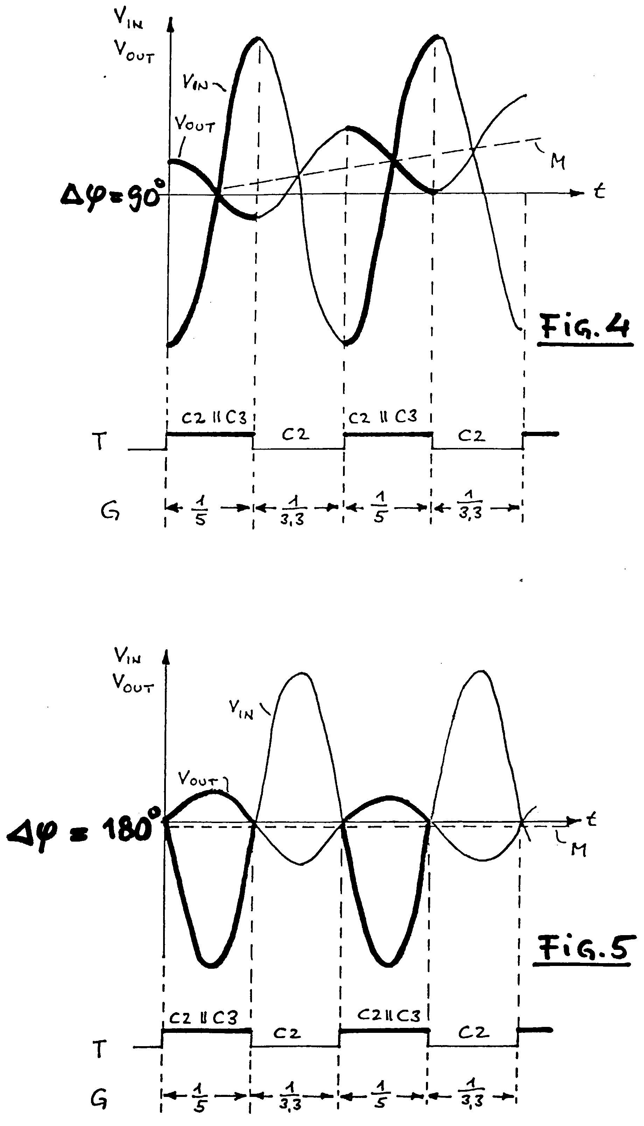

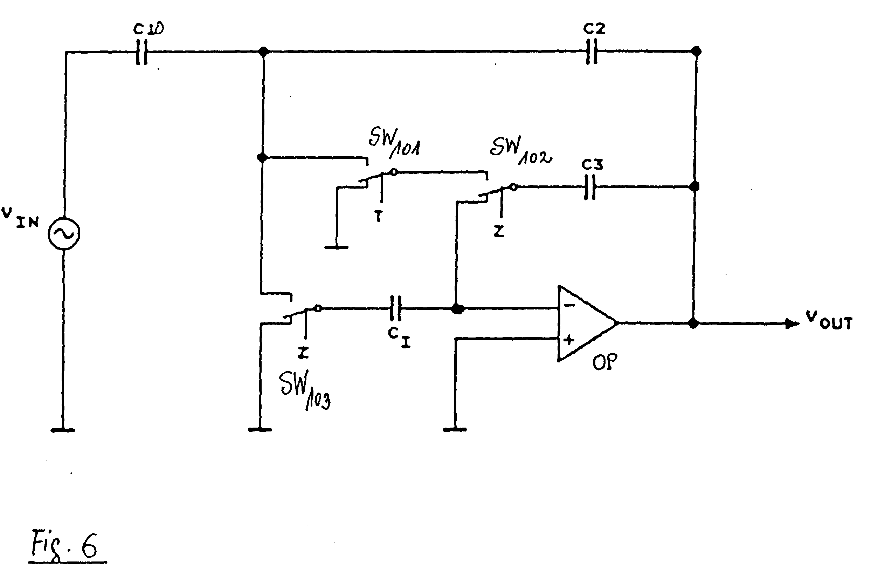

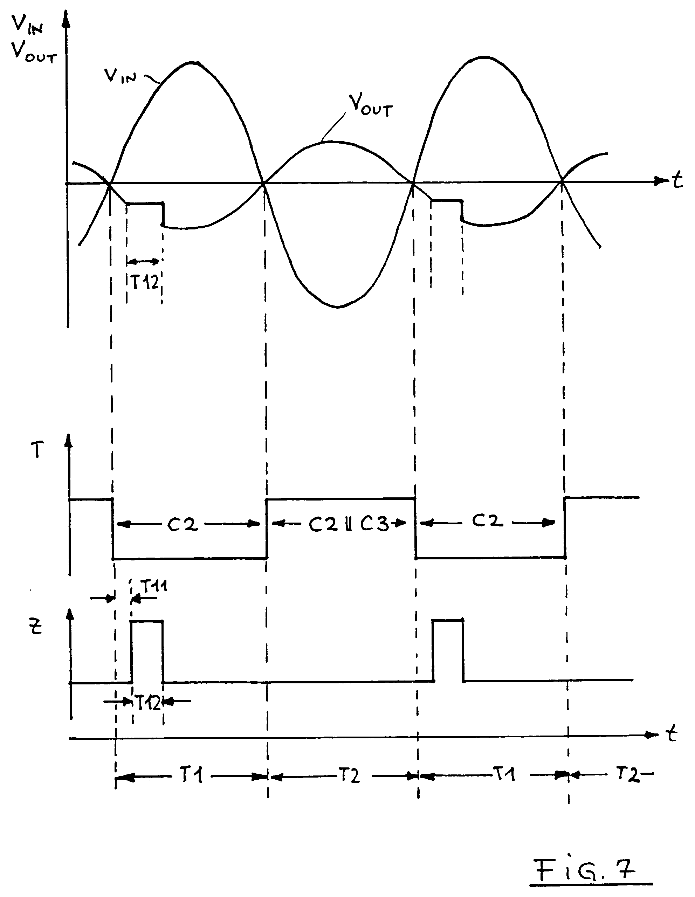

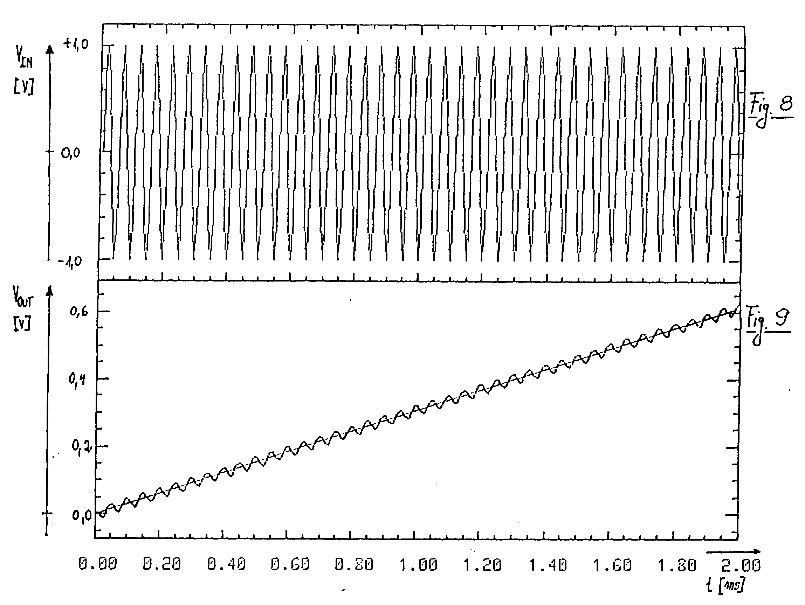

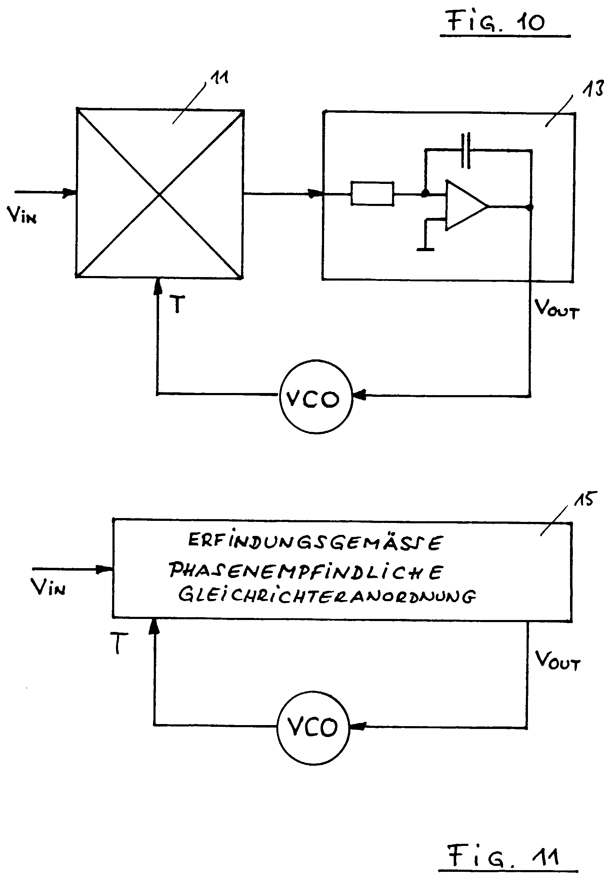

Die Arbeitsweise der erfindungsgemäßen phasenempfindlichen Gleichrichteranordnung wird nun anhand von Zeitdiagrammen in den Fig. 4 und 5 näher erläutert. Dabei sind zwei Beispiele hinsichtlich der Phasenbeziehung zwischen dem Eingangssignal $V_{IN}$ und dem Steuersignal T herausgegriffen. Bei dem in Fig. 4 dargestellten Beispiel wird ein Phasenunterschied $\Delta \phi = 90°$ angenommen. Bei dem in Fig. 5 gezeigten Beispiel wird ein Phasenunterschied $\Delta \phi = 180°$, also gegenphasigkeit, angenommen. Das gleiche Ergebnis erhält man bei Gleichphasigkeit, also bei $\Delta \phi = 0°$. Selbstverständlich können beliebige andere Phasenunterschiede zwischen Eingangssignal und Steuersignal auftreten.

Bei der in Fig. 3 gezeigten Ausführungsform einer erfindungsgemäßen phasenempfindlichen Gleichrichteranordnung koppelt die erste Kapazität $c_{10}$ die Eingangsspannung $V_{IN}$ auf den invertierenden Eingang des Operationsverstärkers OP. Mittels der Umschalteinrichtung SW wird die dritte Kapazität $C_3$ je nach dem Momentanwert des Steuersignals T der zweiten Kapazität $C_2$ parallel geschaltet oder auf das Referenzpotential oder Masse gelegt. Diese Maßnahme führt dazu, daß der Operationsverstärker OP eine umschaltbare Gegenkopplung aufweist, die abwechselnd entweder nur durch die zweite Kapazität $C_2$ oder durch die Parallelschaltung der Kapazitäten $C_2$ und $C_3$ gebildet wird. Sind beide Kapazitäten parallel geschaltet, ist die Gegenkopplungswirkung für den Operationsverstärker OP stärker und bei einem bestimmten Eingangssignal $V_{IN}$ wird das Ausgangssignal kleiner als wenn die Gegenkopplung nur über $C_2$ geschieht.

Aufgrund der Gegenkopplung des Operationsverstärkers OP ist die Ausgangsspannung $V_{OUT}$ kleiner als die Eingangsspannung $V_{IN}$. Der gegengekoppelte Operationsverstärker OP weist somit eine Verstärkung kleiner als 1 auf, wie in den Fig. 4 und 5 dargestellt ist. Rein beispielsweise ist in den Fig. 4 und 5 angenommen, daß die Verstärkung während der Parallelschaltung von $C_2$ und $C_3$ einen Wert von 1/5 aufweist und während derjenigen Zeiten, während welcher die Gegenkopplung nur durch $C_2$ bestimmt ist, einen Wert von 1/3,3 aufweist.

Betrachtet man zunächst das Zeitdiagramm in Fig. 4, sind während der ansteigenden Flanke des Eingangssignals $V_{IN}$ beide Kapazitäten $C_2$ und $C_3$ parallel geschaltet, während der abfallenden Flanken des Eingangssignals $V_{IN}$ dagegen ist nur $C_2$ wirksam. Der abfallenden Flanke des Ausgangssignals $V_{OUT}$ schließt sich daher eine ansteigende Flanke dieses Ausgangssignals $V_{OUT}$ an, deren Ende aufgrund der größeren Verstärkung oder geringeren Dämpfung des Eingangssignals während dieser Zeitdauer höher liegt als der Beginnpunkt der ersten in Fig. 4 dargestellten abfallenden Flanke des Ausgangssignals $V_{OUT}$. Dieser Anstieg des jeweiligen Endpunktes der ansteigenden Flanke des Ausgangssignals $V_{OUT}$ setzt sich über die weiteren Perioden des Ausgangssignals $V_{OUT}$ fort, so daß dessen Mittelwert ansteigt. Dies ist in Fig. 4 durch eine gestrichelte Linie M dargestellt.

Bei einem Phasenunterschied von 90° zwischen dem Eingangssignal $V_{IN}$ und dem Steuersignal T steigt also der Mittelwert M des Ausgangssignals an, was eine integrierende Wirkung bedeutet.

Betrachtet man nun den in Fig. 5 dargestellten Fall entgegengesetzter Phase zwischen Eingangssignal $V_{IN}$ und Steuersignal T, so sieht man, daß die Dämpfung zwischen Eingangssignal $V_{IN}$ und Ausgangssignal $V_{OUT}$ zwischen den aufeinanderfolgenden Halbperioden zwar unterschiedlich ist, daß sich jedoch ein Mittelwert M ergibt, der konstant ist. Das integrierte Signal ist somit konstant, im Gegensatz zu dem in Fig. 4 gezeigten Fall eines Phasenunterschiedes von 90° zwischen Eingangssignal $V_{IN}$ und Steuersignal T.

Ein Vergleich der Fig. 4 und 5 zeigt somit, daß die erfindungsgemäße Schaltung sowohl als phasenempfindlicher Gleichrichter als auch als Integrator wirkt.

Die Arbeitsweise der erfindungsgemäßen phasenempfindlichen Gleichrichteranordnung kann man auch wieder anhand von Ladungsvorgängen betrachten. Verknüpfung der unterschiedlichen Betrachtungen ist die bekannte Beziehung, wonach Ladung das Produkt aus Kapazität und Spannung ist.

Für die nachfolgende Betrachtung der Ladungsverhältnisse wird von dem Beispiel ausgegangen, daß es sich bei der Eingangsspannung $V_{IN}$ um eine Sinuswechselspannung handelt, die gegenüber der Steuerspannung T eine Phasendifferenz von 90° aufweist. Diese Sinuswechselspannung wird der ersten Kapazität $C_{10}$ als Eingangssignal $V_{IN}$ zugeführt. Während der fallenden Flanke des Eingangssignals $V_{IN}$ wird die in der ersten Kapazität $C_{10}$ gesammelte Ladung auf die in der Rückkoppelungsschleife des Operationsverstärkers OP angeordnete zweite Kapazität $C_2$ übertragen. Während dieser Zeit, in der das Steuersignal T den ersten Pegel annimmt, ist der erste Anschluß der dritten Kapazität $C_3$ durch die steuerbare Umschalteinrichtung SW auf das Referenzpotential gelegt. Während der ansteigenden Flanke des Eingangssignals $V_{IN}$ wird die in der ersten Kapazität $C_{10}$ gesammelte Ladung von der auf der zweiten Kapazität $C_2$ gesammelten Ladung subtrahiert. Da jedoch das Steuersignal T in diesem Zeitraum den zweiten Pegel annimmt, ist die dritte Kapazität $C_3$ über die steuerbare Umschalteinrichtung SW der zweiten Kapazität $C_2$ parallelgeschaltet. Somit verbleibt eine kleine Ladung in der zweiten Kapazität $C_2$. Dieser Ablauf wiederholt sich für jede Periode des Eingangssignals $V_{IN}$, so daß diese kleinen Ladungsmengen sich ansammeln.

Die Zeitkonstante $\tau$ des Integrators bestimmt sich zu

$$\tau \approx \frac{C_2^{\ 2}}{C_{10} \cdot C_3} \cdot \underline{T} \qquad (\text{für } C_2 >> C_{10}, C_3) \qquad (1)$$

wobei die Taktperiode des Steuersignals T mit $\underline{T}$ bezeichnet ist. Da der Kapazitätswert der zweiten Kapazität $C_2$ bei der Berechnung der Zeitkonstante $\tau$ nach Gleichung (1) quadratisch eingeht, können große Zeitkonstanten bei mäßig großen Verhältnissen zwischen dem Kapazitätswert der zweiten Kapazität $C_2$ und dem Produkt der Kapazitätswerte der ersten Kapazität $C_{10}$ und der dritten Kapazität $C_3$ realisiert werden.

**Fig. 6** zeigt ein Schaltbild einer zweiten Ausführungsform einer erfindungsgemäßen phasenempfindlichen Gleichrichteranordnung mit Integrationswirkung, die mit einer Offset-Kompensation versehen ist. Diese Ausführung besitzt eine erste, zweite und dritte steuerbare Umschalteinrichtung $SW_{101}$, $SW_{102}$ bzw. $SW_{103}$. (In den Ansprüchen ist die erste steuerbare Umschalteinrichtung dritte steuerbare Umschalteinrichtung bezeichnet und umgekehrt.) Jede der steuerbaren Umschalteinrichtungen $SW_{101}$, $SW_{102}$, $SW_{103}$ weist jeweils einen ersten Anschluß, einen zweiten Anschluß und einen Mittenanschluß auf. In Abhängigkeit von einem jeweils angelegten ersten oder zweiten elektrischen Steuersignal T, Z ist bei einem ersten Pegel des jeweiligen Steuersignals T, Z der erste Anschluß mit dem Mittenanschluß und der zweite Anschluß nicht mit dem Mittenanschluß verbunden, während bei einem zweiten Signalpegel des jeweiligen Steuersignals T, Z der erste Anschluß nicht mit dem Mittenanschluß und der zweite Anschluß mit dem Mittenanschluß verbunden ist.

Der Ausgang einer Signalquelle wird als Eingangssignal $V_{IN}$ einem ersten Anschluß einer ersten Kapazität $C_{10}$ zugeführt. Der zweite Anschluß der ersten Kapazität $C_{10}$ ist unmittelbar an einen ersten Anschluß einer zweiten Kapazität $C_2$, an den ersten Anschluß der ersten, in Abhängigkeit von dem ersten Steuersignal T steuerbaren Umschalteinrichtung $SW_{101}$, und an den ersten Anschluß der dritten, in Abhängigkeit von dem zweiten Steuersignal Z steuerbaren Umschalteinrichtung $SW_{103}$ geschaltet. Der zweite Anschluß der ersten steuerbaren Umschalteinrichtung $SW_{101}$ sowie der zweite Anschluß der dritten steuerbaren Umschalteinrichtung $SW_{103}$ sind auf ein Referenzpotential gelegt. Der Mittenanschluß der ersten steuerbaren Umschalteinrichtung $SW_{101}$ ist unmittelbar an den ersten Anschluß der zweiten steuerbaren Umschalteinrichtung $SW_{102}$ geschaltet. Zwischen den Mittenanschluß der zweiten steuerbaren Umschalteinrichtung $SW_{102}$ und den Ausgang eines Operationsverstärkers OP ist eine dritte Kapazität $C_3$ geschaltet, wobei ein erster Anschluß der dritten Kapazität C3 an den Mittenanschluß der zweiten steuerbaren Umschalteinrichtung $SW_{102}$ und ein zweiter Anschluß der dritten Kapazität $C_3$ an den Ausgang des Operationsverstärkers OP gelegt ist. Der zweite Anschluß der zweiten steuerbaren Umschalteinrichtung $SW_{102}$ ist unmittelbar an den invertierenden Eingang des Operationsverstärkers OP geschaltet. Der zweite Anschluß der zweiten Kapazität $C_2$ ist unmittelbar an den Ausgang des Operationsverstärkers OP geschaltet. Zwischen den Mittenanschluß der dritten steuerbaren Umschalteinrichtung $SW_{103}$ und den invertierenden Eingang des Operationsverstärkers OP ist eine vierte Kapazität $C_I$ geschaltet. Der nicht-invertierende Eingang des Operationsverstärkers OP ist auf das Referenzpotential gelegt. Das Ausgangssignal $V_{OUT}$ der phasenempfindlichen Gleichrichteranordnung wird an dem Ausgang des Operationsverstärkers OP abgenommen.

Das vorstehend beschriebene zweite Ausführungsbeispiel einer erfindungsgemäßen phasenempfindlichen Gleichrichteranordnung arbeitet in mehreren Betriebszuständen, die im folgenden mit Bezug auf **Fig. 7** erklärt werden.

**Fig. 7** zeigt ein Zeitdiagramm der Steuersignale T und Z. Das erste Steuersignal T kann entweder einen ersten (niedrigen) Signalpegel oder einen zweiten (hohen) Signalpegel annehmen. Ebenso kann das zweite Steuersignal Z entweder einen ersten (niedrigen) Signalpegel oder einen zweiten (hohen) Signalpegel annehmen. Zu Beginn eines ersten Zeitraumes T1, in dem das erste Steuersignal T den ersten Pegel annimmt, gibt es einen kleineren zweiten Zeitraum T11, in dem das zweite Steuersignal Z den ersten Pegel annimmt. Während dieser Zeit ist der erste Anschluß der dritten Kapazität $C_3$ über die erste steuerbare Umschalteinrichtung $SW_{101}$ sowie über die zweite Umschalteinrichtung $SW_{102}$ auf das Referenzpotential gelegt, so daß die dritte Kapazität $C_3$ bei diesem Zustand der Umschalteinrichtungen $SW_{101}$, $SW_{102}$ und $SW_{103}$ für die phasenempfindliche Gleichrichteranordnung nicht wirksam ist. Nach dem Ende des zweiten Zeitraumes T11 ändert sich der -Zustand des zweiten Steuersignals Z, welches nunmehr während eines dritten Zeitraumes T12 den zweiten Pegel annimmt. Während des Zeitraums T12 nimmt die Schaltung nach Fig. 6 die dort gezeigten Zustände der Umschalteinrichtungen ein. Während dieses dritten Zeitraumes T12, der ebenso wie der zweite Zeitraum T11 zur Gänze innerhalb des ersten Zeitraumes T1 liegt, übernimmt die vierte Kapazität $C_I$ über die zweiten und dritten steuerbaren Umschalteinrichtungen $SW_{102}$, $SW_{103}$ eine der Offsetspannung des Operationsverstärkers OP entsprechende Ladungsmenge zum automatischen Nullabgleich der Schaltung.

An den ersten Anschluß der ersten Kapazität $C_{10}$ wird eine Sinuswechselspannung $V_{IN}$ als Eingangssignal angelegt. Während der fallenden Flanke des Eingangssignals $V_{IN}$ wird die in der ersten Kapazität $C_{10}$ gesammelte Ladung auf die in der Rückkoppelungsschleife des Operationsverstärkers OP angeordnete zweite Kapazität $C_2$ übertragen. Während dieses ersten Zeitraumes T1, in dem das erste Steuersignal T den ersten Pegel und das zweite Steuersignal Z den ersten oder zweiten Pegel annimmt, findet entweder der vorstehend beschriebene automatische Nullabgleich statt oder der erste Anschluß der dritten Kapazität $C_3$ ist durch die ersten und zweiten steuerbaren Umschalteinrichtungen $SW_{101}$ und $SW_{102}$ auf das Referenzpotential gelegt. Während der ansteigenden Flanke des Eingangssignals $V_{IN}$ wird die in der ersten Kapazität $C_{10}$ gesammelte Ladung von der auf der zweiten Kapazität $C_2$ gesammelten Ladung subtrahiert. Da jedoch das erste Steuersignal T währenddessen in einem auf den ersten Zeitraum T1 unmittelbar folgenden vierten Zeitraum T2 den zweiten Pegel und das zweite Steuersignal Z den ersten Pegel annimmt, ist die dritte Kapazität $C_3$ über die steuerbare Umschalteinrichtungen $SW_{101}$ und $SW_{102}$ der zweiten Kapazität $C_2$ parallelgeschaltet. Somit verbleibt eine kleine Ladung in der zweiten Kapazität $C_2$. Dieser Ablauf wiederholt sich für jede Periode des Eingangssignals $V_{IN}$, so daß diese kleinen Ladungsmengen sich ansammeln.

In Fig. 7 sind die Eingangsspannung $V_{IN}$ und die Ausgangsspannung $V_{OUT}$ dargestellt, um die Beziehung zwischen diesen beiden Spannungen und den Steuersignalen T und Z zu verdeutlichen. Als reines Beispiel ist dabei angenommen, daß zwischen der Eingangsspannung $V_{IN}$ und dem Steuersignal T Gegenphasigkeit besteht. Das Zeitdiagramm der Fig. 7 stimmt daher hinsichtlich Eingangsspannung $V_{IN}$, Ausgangsspannung $V_{OUT}$ und Steuersignal T mit Fig. 5 überein.

Ein Vergleich der Fig. 3 und 6 zeigt, daß die Ausführungsform nach Fig. 6 genau wie die in Fig. 3 gezeigte Ausführungsform arbeitet, wenn die Umschalteinrichtung $SW_{102}$ die Kapazität $C_3$ mit der Umschalteinrichtung $SW_{101}$ verbindet. Dies gilt bei dem in Fig. 7 gezeigten Beispiel außerhalb der Zeiten T12 des Steuersignals Z. Während dieser Zeiten wird die Kapazität $C_I$ von der Umschalteinrichtung $SW_{103}$ mit dem Verbindungspunkt zwischen den Kapazitäten $C_{10}$ und $C_2$ verbunden.

Während der Zeitabschnitte T12 des Steuersignals Z wird die Kapazität $C_3$ über die Umschalteinrichtung $SW_{102}$ mit dem invertierenden Eingang des Operationsverstärkers verbunden und ist die Kapazität $C_I$ über die Umschalteinrichtung $SW_{103}$ mit dem Referenzpotential oder Masse verbunden.

Die dritte Kapazität $C_3$ hat somit eine Doppelfunktion. Während der Halbperioden T2 des Steuersignals T wirkt $C_3$ bei der Gegenkopplung des Operationsverstärkers OP mit. Während der Zeitabschnitte T12 des Steuersignals Z innerhalb der anderen Halbperioden T1 des Steuersignals T wirkt $C_3$ bei der Offset-Kompensation mit. Die dritte Kapazität $C_3$ wird also immer nur dann zur Offset-Kompensation eingesetzt, wenn sie keine Mitwirkung zur Gegenkopplung des Operationsverstärkers OP hat.

Die steuerbaren Umschalteinrichtungen werden in einer bevorzugten Ausführungsform unter Verwendung von Biploar- oder MOS- Transistoren aufgebaut.

Fig. 8 zeigt ein Zeitdiagramm einer sinusförmigen Eingangsspannung $V_{IN}$, die dem Eingang einer erfindungsgemäßen phasenempfindlichen Gleichrichteranordnung zugeführt wird. Dieser Signalverlauf entspricht den Signalverläufen von $V_{IN}$ in den Fig. 4 und 5, jedoch mit einem anderen Maßstab der Zeitskala t.

Fig. 9 zeigt einen Signalverlauf einer Ausgangsspannung $V_{OUT}$ der in Fig. 4 dargestellten Art, wiederum mit einem anderen Maßstab der Zeitskala t als in Fig. 4. Die durchgehende gestrichelte Linie in Fig. 9 entspricht der linear ansteigenden gestrichelten Mittelwertlinie in Fig. 4 und ist daher ebenfalls mit M gekennzeichnet. Der Mittelwertlinie M in Fig. 9 ist ein sinusförmiger Verlauf überlagert. Dieser entspricht dem entsprechend der Mittelwertlinie M ansteigenden Sinusverlauf der Ausgangsspannung $V_{OUT}$ in Fig. 4.

In Anwendungsfällen, in denen der dem Mittelwert M überlagerte Sinusverlauf der Ausgangsspannung $V_{OUT}$ sich störend auswirken könnte, kann eine Glättung durch eine dem Ausgang des Operationsverstärkers OP nachgeschaltete Schaltungsanordnung, beispielsweise eine Abtasthalteschaltung ("sample- and -hold"-Schaltung) erreicht werden.

Ein Anwendungsbeispiel der erfindungsgemäßen phasenempfindlichen Gleichrichteranordnung ist die Verwendung in einer PLL.

Fig. 10 zeigt eine PLL mit herkömmlichem Schaltungsaufbau. Einem spannungsgesteuerten Oszillator VCO ist eine Reihenschaltung aus einem herkömmlichen phasenempfindlichen Gleichrichter 11 und einem herkömmlichen Integrator 13 parallel geschaltet. Dem phasenempfindlichen Gleichrichter 11 wird ein Eingangssignal $V_{IN}$ zugeführt, auf welches die Frequenz VCO einrasten soll. Das Ausgangssignal von VCO wird dem phasenempfindlichen Gleichrichter in Form des Steuersignals T als zweites Eingangssignal zugeführt. Das Ausgangssignal $V_{OUT}$ des Integrators 13 wird VCO als Eingangssignal zugeführt.

Fig. 11 zeigt eine PLL, die mit einer erfindungsgemäßen phasenempfindlichen Gleichrichteranordnung 15 aufgebaut ist. Diese ist beispielsweise gemäß Fig. 3 aufgebaut. Ihre Ausgangsspannung $V_{OUT}$ steuert VCO. Dessen Ausgangssignal T wird von der phasenempfindlichen Gleichrichteranordnung 15 mit dem Eingangssignal $V_{IN}$ phasenmäßig verglichen.

Bei einer erfindungsgemäß aufgebauten PLL arbeitet der spannungsgesteuerte Oszillator VCO somit nur noch mit einer einzigen Schaltung zusammen, die gleichzeitig sowohl die Funktion eines phasenempfindlichen Gleichrichters als auch die Funktion eines Integrators aufweist. Eine derart aufgebaute PLL kommt daher mit vergleichsweise wenigen Schaltungskomponenten aus. Dies ist besonders vorteilhaft und wichtig bei monolithischer Integration.

**Patentansprüche**

1. Phasenempfindliche Gleichrichteranordnung mit Integrationswirkung zur Verknüpfung zweier Eingangssignale,

   a) mit einem Operationsverstärker (OP), der einen invertierenden Eingang, einen nicht-invertierenden Eingang und einen Ausgang aufweist,
   b) mit einer ersten Kapazität (C10), die einen Endes an den invertierenden Eingang und anderen Endes an eine ein erstes Eingangssignal liefernde Eingangssignalquelle ($V_{IN}$) angeschlossen ist,
   c) wobei der nicht-invertierende Eingang an einen Referenzpotentialanschluß angeschlossen ist,
   d) mit einer zweiten Kapazität (C2), die einen Endes an den invertierenden Eingang und anderen Endes an den Ausgang des Operationsverstärkers (OP) angeschlossen ist,
   e) und mit einer dritten Kapazität (C3), die einen Endes an den Ausgang des Operationsverstärkers (OP) und anderen Endes an eine steuerbare Umschalteinrichtung (SW), die mittels eines als Steuersignal (T) dienenden zweiten Eingangssignals steuerbar ist, angeschlossen und in Abhängigkeit von dem Steuersignal (T) entweder mit dem invertierenden Eingang verbindbar oder an den Referenzpotentialeingang anschließbar ist.

2. Phasenempfindliche Gleichrichteranordnung mit Integrationswirkung zur Verknüpfung zweier Eingangssignale,

   a) mit einem Operationsverstärker (OP), der einen invertierenden Eingang, einen nicht-invertierenden Eingang und einen Ausgang aufweist,

   b) dessen nicht-invertierender Eingang an einen Referenzpotentialanschluß angeschlossen ist,
   c) dessen invertierender Eingang über eine Reihenschaltung mit einer ein erstes Eingangssignal liefernde Eingangssignalquelle ($V_{IN}$) verbunden ist,
   d) wobei die Reihenschaltung eine erste Kapazität (C10) aufweist sowie eine zweite Kapazität ($C_I$) und dazwischen eine erste steuerbare Umschalteinrichtung ($SW_{103}$), welche die zweite Kapazität ($C_I$) in einer ersten Schaltstellung mit der ersten Kapazität (C10) verbindet und in einer zweiten Schaltstellung an einen Referenzpotentialanschluß legt,
   e) mit einer dritten Kapazität ($C_3$), die einen Endes an den Ausgang des Operationsverstärkers (OP) und anderen Endes an eine zweite steuerbare Umschalteinrichtung ($SW_{102}$) angeschlossen ist, welche die dritte Kapazität (C3) in einer ersten Schaltstellung mit dem invertierenden Eingang und in einer zweiten Schaltstellung mit einer dritten steuerbaren Umschalteinrichtung ($SW_{101}$) verbindet, welche bei in der zweiten Schaltstellung befindlicher zweiter Umschalteinrichtung ($SW_{102}$) die dritte Kapazität (C3) in einer ersten Schaltstellung mit einem Verbindungspunkt zwischen der ersten Kapazität (C10) und der ersten Umschalteinrichtung ($SW_{103}$) und in einer zweiten Schaltstellung mit dem Referenzpotentialanschluß verbindet,
   f) und mit einer vierten Kapazität (C2), die einen Endes an den Ausgang des Operationsverstärkers (OP) und anderen Endes mit dem Verbindungspunkt zwischen der ersten Kapazität (C10) und der ersten Umschalteinrichtung ($SW_{103}$) verbunden ist,
   g) wobei die dritte Umschalteinrichtung ($SW_{101}$) mittels eines als ein erstes Steuersignal dienenden zweiten Eingangssignals (T) und die erste Umschalteinrichtung ($SW_{103}$) und die zweite Umschalteinrichtung ($SW_{102}$) mittels eines zweiten Steuersignals (Z) steuerbar sind, derart, daß
   h) während eines ersten Zeitraums (T1) die erste Umschalteinrichtung ($SW_{103}$) in ihren ersten Schaltzustand und die zweite Umschalteinrichtung ($SW_{102}$) und die dritte Umschalteinrichtung ($SW_{101}$) je in ihren zweiten Schaltzustand,
   i) während eines an den ersten Zeitraum (T1) anschließenden zweiten Zeitraums (T2) die erste Umschalteinrichtung ($SW_{103}$) und die dritte Umschalteinrichtung ($SW_{101}$) je in ihren ersten Schaltzustand und die zweite Umschalteinrichtung ($SW_{102)}$ in ihren zweiten Schaltzustand
   i) und während eines Teils (T12) des ersten Zeitraums (T1) die erste Umschalteinrichtung (SW$_{103}$) und die zweite Umschalteinrichtung (SW$_{102}$) abweichend von den Schaltzuständen, welche sie während des restlichen Teils des ersten Zeitraums (T1) innehaben, in ihren zweiten bzw. ersten Schaltzustand gesteuert sind.

3. Phasenempfindliche Gleichrichteranordnung nach Anspruch 1 oder 2, dadurch gekennzeichnet, daß die steuerbaren Umschalteinrichtungen (SW, SW$_{101}$, SW$_{102}$, SW$_{103}$) mit Transistoren aufgebaut sind.

4. Phasenempfindliche Gleichrichteranordnung nach einem der Ansprüche 1-3, dadurch gekennzeichnet, daß die Anordnung eine dem Ausgang des Operationsverstärkers (OP) nachgeschaltete Abtasthalteschaltung aufweist.

5. PLL mit einem spannungsgesteuerten Oszillator (VCO),
dadurch gekennzeichnet,

daß dem spannungsgesteuerten Oszillator (VCO) eine phasenempfindliche Gleichrichteranordnung (15) nach einem der Ansprüche 1 bis 4 parallel geschaltet ist
und daß der Eingang des spannungsgesteuerten Oszillators (VCO) mit dem Ausgang der phasenempfindlichen Gleichrichteranordnung (15) und deren das Steuersignal (T) empfangender Eingang mit dem Ausgang des spannungsgesteuerten Oszillators (VCO) verbunden ist.

**Claims**

1. A phase-sensitive rectifier arrangement with integration effect for linking two input signals, comprising

    a) an operational amplifier (OP) having an inverting input, a non-inverting input and an output,
    b) a first capacitor (C10) having one end connected to said inverting input and the other end connected to an input signal source (V$_{IN}$) delivering a first input signal,
    c) with said non-inverting input being connected to a reference potential terminal,
    d) a second capacitor (C$_2$) having one end connected to said inverting input and the other end connected to the output of the operational amplifier (OP),
    e) and comprising a third capacitor (C3) having one end connected to the output of the operational amplifier (OP) and the other end connected to a controllable switching means (SW) that is controllable by means of a second input signal serving as control signal (T), with said third capacitor (C3) being adapted to be connected either to the inverting input or to the reference potential terminal, depending on said control signal (T).

2. A phase-sensitive rectifier arrangement with integration effect for linking two input signals, comprising

    a) an operational amplifier (OP) having an inverting input, a non-inverting input and an output,
    b) the non-inverting input thereof being connected to a reference potential terminal,
    c) the inverting input thereof being connected, via a series connection, to an input signal source (V$_{IN}$) delivering a first input signal,
    d) said series connection comprising a first capacitor (C10) and a second capacitor (C1) and therebetween a first controllable switching means (SW$_{103}$) connecting the second capacitor (C1) to the first capacitor (C10) in a first switching position and applying the same to a reference potential terminal in a second switching position,
    e) a third capacitor (C3) having one end connected to the output of the operational amplifier (OP) and the other end connected to a second controllable switching means (SW$_{102}$) connecting the third capacitor (C3) to the inverting input in a first switching position and to a third controllable switching means (SW$_{101}$) in a second switching position, with said third controllable switching means (SW$_{101}$), when said second switching means (SW$_{102}$) is in the second switching position, connecting the third capacitor (C3) in a first switching position to a connecting node between the first capacitor (C10) and the first switching means (SW$_{103}$), and in a second switching position to the reference potential terminal,
    f) and a fourth capacitor (C2) having one end connected to the output of the operational amplifier (OP) and the other end connected to the connecting node between the first capacitor (C10) and the first switching means (SW$_{103}$),
    g) with said third switching means (SW$_{101}$) being controllable via a second input signal (T) serving as first control signal, and said first switching means (SW$_{103}$) and said second switching means (SW$_{102}$) being controllable by means of a second control signal (Z) such that,
    h) during a first period of time (T1), the first switching means (SW$_{103}$) is controlled to its first switching state and the second switching means (SW$_{102}$) and the third switching means (SW$_{101}$) are controlled to their second switching states each,

i) during a second period of time (T2) following said first period of time (T1), the first switching means (SW$_{103}$) and the third switching mans (SW$_{101}$) are controlled to their first switching states each and the second switching means (SW$_{102}$) is controlled to its second switching state,

j) and during part (T12) of said first period of time (T1), the first switching means (SW$_{103}$) and the second switching means (SW$_{102}$), differently from the switching states thereof in the remainder of the first period of time (T1), are controlled to their second and first switching states, respectively.

3. A phase-sensitive rectifier arrangement according to claim 1 or 2,
characterized in that the controllable switching means (SW, SW$_{101}$, SW$_{102}$, SW$_{103}$) are composed with transistors.

4. A phase-sensitive rectifier arrangement according to any one of claims 1 to 3,
characterized in that the arrangement comprises a sample and hold circuit connected downstream of the output of the operational amplifier (OP).

5. A PLL having a voltage controlled oscillator (VCO),
characterized in that the voltage controlled oscillator (VCO) has a phase-sensitive rectifier arrangement (15) according to any one of claims 1 to 4 connected in parallel thereto, and in that the input of the voltage controlled oscillator (VCO) is connected to the output of the phase-sensitive rectifier arrangement (15) and the input of the latter, receiving the control signal (T), is connected to the output of the voltage controlled oscillator (VCO).

## Revendications

1. Dispositif redresseur sensible à la phase avec effet intégrateur pour combiner deux signaux d'entrée, comprenant :

a) un amplificateur opérationnel (OP) ayant une entrée inverseuse, une entrée non-inverseuse, et une sortie,
b) un premier condensateur (C10), relié par une borne à l'entrée inverseuse et par l'autre borne à une source de tension d'entrée (V$_{IN}$) fournissant une première tension d'entrée,
c) l'entrée inverseuse étant reliée à une borne de potentiel de référence,

d) comprenant un deuxième condensateur (C2) relié par une borne à l'entrée inverseuse et par l'autre borne à la sortie de l'amplificateur opérationnel (OP),
e) et un troisième condensateur (C3) relié par une borne à la sortie de l'amplificateur opérationnel (OP) et par l'autre borne à un commutateur (SW) commandé par un deuxième signal d'entrée servant de signal de commande (T) et reliant le condensateur à l'entrée inverseuse ou à l'entrée de potentiel de référence selon l'état du signal de commande (T).

2. Dispositif redresseur sensible à la phase avec effet intégrateur pour combiner deux signaux d'entrée,

a) comprenant un amplificateur opérationnel (OP) ayant une entrée inverseuse, une entrée non-inverseuse, et une sortie,
b) l'entrée non-inverseuse étant reliée à une borne de potentiel de référence,
c) l'entrée inverseuse étant reliée à une source de signal d'entrée (V$_{IN}$) fournissant un premier signal d'entrée, par l'intermédiaire d'une connexion série,
d) la connexion série comprenant un premier condensateur (C10) ainsi qu'un deuxième condensateur (C$_I$) et, entre les deux condensateurs, un premier commutateur commandé (SW$_{103}$) qui, dans une première position de commutation, relie le deuxième condensateur (C$_I$) au premier condensateur (C10) et, dans une deuxième position de commutation, relie le deuxième condensateur à une borne de potentiel de référence,
e) comprenant un troisième condensateur (C3) relié par une borne à la sortie de l'amplificateur opérationnel (OP) et par l'autre borne à un deuxième commutateur commandé (SW$_{102}$) qui relie le troisième condensateur (C3), dans une première position de commutation, à l'entrée inverseuse et, dans une deuxième position de commutation, à un troisième commutateur commandé (SW$_{101}$) qui, lorsque le deuxième commutateur (SW$_{102}$) se trouve dans la deuxième position de commutation, relie le troisième condensateur (C3), dans une première position de commutation, à un noeud de connexion entre le premier condensateur (C10) et le premier commutateur (SW$_{103}$) et, dans une deuxième position de commutation, relie le troisième condensateur à la borne de potentiel de référence,
f) et comprenant un quatrième condensateur (C2), relié par une borne à la sortie de l'amplificateur opérationnel (OP) et par l'autre borne (OP) au noeud de connexion entre le premier condensateur (C10) et le premier commutateur

(SW$_{103}$),

g) le troisième commutateur (SW$_{101}$) étant commandé au moyen d'un deuxième signal d'entrée (T) servant de premier signal de commande et le premier commutateur (SW$_{103}$) et le deuxième commutateur (SW$_{102}$) étant commandés par un deuxième signal de commande (Z), de manière que

h) pendant un premier intervalle de temps (T1) le premier commutateur (SW$_{103}$) soit mis dans sa première position de commutation et le deuxième commutateur (SW$_{102}$) et le troisième commutateur (SW$_{101}$) soient mis dans leur deuxième position de commutation,

i) pendant un deuxième intervalle de temps (T2) suivant le premier intervalle de temps (T1), le premier commutateur (SW103) et le troisième commutateur (SW$_{101}$) soient, chacun, mis dans leur première position de commutation, et le deuxième commutateur (SW$_{102}$) soit mis dans sa deuxième position de commutation,

j) et, pendant une partie (T12) du premier intervalle de temps (T1), le premier commutateur (SW$_{103}$) et le deuxième commutateur (SW$_{102}$) sont écartés des positions de commutation qu'ils avaient pendant la partie restante du premier intervalle de temps (T1) vers leurs deuxième et première positions de commutation, respectivement.

3. Dispositif redresseur sensible à la phase selon la revendication 1 ou 2, caractérisé en ce que les commutateurs commandés (SW, SW$_{101}$, SW$_{102}$, SW$_{103}$) sont constitués de transistors.

4. Dispositif redresseur sensible à la phase selon l'une quelconque des revendications 1 à 3, caractérisé en ce que le montage comprend un échantillonneur-bloqueur disposé à la sortie de l'amplificateur opérationnel (OP).

5. Boucle à verrouillage de phase munie d'un oscillateur commandé en tension (VCO),
    caractérisé

en ce qu'un dispositif redresseur sensible à la phase (15) selon l'une quelconque des revendications 1 à 4, est connecté en parallèle sur l'oscillateur commandé en tension (VCO), et en ce que l'entrée de l'oscillateur commandé en tension (VCO) est reliée à la sortie du dispositif redresseur sensible à la phase (15) dont l'entrée recevant le signal de commande (T) est reliée à la sortie de l'oscillateur commandé en tension (VCO).

Fig. 1

Fig. 2

Fig. 3

Fig.4

Fig.5

15

Fig. 6

F i G. 7

Fig. 8

Fig. 9

FiG. 10

ERFINDUNGSGEMÄSSE
PHASENEMPFINDLICHE
GLEICHRICHTERANORDNUNG

FiG. 11